# EUROPÄISCHE PATENTSCHRIFT

(11) **EP 1 319 170 B1**
(45) Veröffentlichungstag und Bekanntmachung des Hinweises auf die Patenterteilung: **09.03.2005**
(21) Anmeldenummer: 01980355.0
(22) Anmeldetag: 08.09.2001
(51) Int. Cl.: G01D 5/38, G01D 5/347, G03F 9/00

(54) **POSITIONSMESSEINRICHTUNG**
POSITION MEASURING DEVICE
DISPOSITIF DE MESURE DE POSITION

(30) Priorität: 14.09.2000 DE 10045846
(43) Veröffentlichungstag der Anmeldung: 18.06.2003
(73) Patentinhaber: Dr. Johannes Heidenhain GmbH, 83292 Traunreut (DE)
(72) Erfinder: HOLZAPFEL, Wolfgang, 83119 Obing (DE); SCHREIBER, Andreas, 63607 Wächtersbach (DE)
(86) Internationale Anmeldenummer: PCT/EP2001/010373
(87) Internationale Veröffentlichungsnummer: WO 2002/023131

(56) Entgegenhaltungen:
- EP-A- 0 387 520
- EP-A- 0 481 356
- FR-A- 2 479 445

## Beschreibung

Die vorliegende Erfindung betrifft eine Positionsmesseinrichtung nach dem Oberbegriff des Anspruches 1.

Bei der Chip-Herstellung durch Wafer-Stepper müssen Maske und Substrat extrem genau positioniert werden. Zu diesem Zweck ist es bekannt, Positionsänderungen des Maskentisches mit Laserinterferometem zu erfassen. Nachteilig ist dabei der Einfluss der Luftunruhe, was letztlich zu Positionsrauschen und Problemen bei der Reproduzierbarkeit führt. Um Effekte der Temperaturausdehnung gering zu halten wäre die Messung der Lage des Substrat- oder Maskentisches direkt und relativ zum optischen Abbildungssystem günstig. Die Montage von Laserinterferometem direkt an der Abbildungsoptik des Wafer-Steppers ist durch räumliche Begrenzung und wegen der thermischen Dissipation jedoch oft nicht möglich und nicht gewünscht, so dass alle Laserinterferometerteile auf einem speziellen Rahmen aus Invar oder Zerodur befestigt sein müssen. Erheblich Probleme bereiten auch das Wechseln der Laser und die Nachjustage der Laserinterferometer. Ein weiterer Nachteil sind die hohen Kosten für die 6 bis 10 benötigten Interferometerachsen.

Anstelle der aufwändigen und teuren Interferometertechnik sind zur Bestimmung von Positionsänderungen in x- und y-Richtung Positionsmesseinrichtungen in Form von Gittermesssystemen denkbar, die mittels eines optischen Messprinzips einen Gittermaßstab abtasten und höhere Reproduzierbarkeiten liefern. Ein solches System ist z.B. in der Veröffentlichung "Maßarbeit - Nanometergenaue Positionsmessung in allen Freiheitsgraden", Y.-B. P. Kwan et al, F & M Jahrg. 108 (2000) 9, S. 60 - 64 beschrieben und besteht aus einem oder zwei Kreuzgitterteilungen und einem oder mehreren Abtastköpfen, die Bewegungen in x- und y-Richtung erfassen. Die Kreuzgitterteilungen sind dabei direkt auf den Maskenhalter aufgebracht.

Um den besonders hohen Anforderungen an die Positioniergenauigkeit und Reproduzierbarkeit in derartigen Anwendungen zu genügen, sind Positionsmesseinrichtungen mit sehr kleinen Signalperioden (≤500nm) und vielen Interpolationsschritten notwendig. Gleichzeitig muss berücksichtigt werden, dass beim Ausrichten der Maske zur Schärfenebene des Objektivs Drehungen des Maskenhalters um alle drei Raumrichtungen auftreten, so dass die Positionsmesseinrichtung Dreh-Toleranzen von etwa ±3 bis ±5mrad bezüglich aller drei Raumrichtungen aufweisen muss. Zusätzlich soll die Positionsmesseinrichtung einen großen Abtastabstand von ca. 5mm-20mm besitzen und eine vergleichsweise hohen Abstandstoleranz von ±1 mm aufweisen.

Aus der EP 0 387 520 B1 der Anmelderin ist eine Positionsmesseinrichtung bekannt, über die bei gewählten Teilungsperioden bzw. Gitterkonstanten von 512nm Signalperioden von 128nm resultieren. Damit lassen sich Positioniergenauigkeiten im Subnanometerbereich erzielen. Verdrehungen des Maßstabs um die Normalenrichtung, nachfolgend Moire-Drehung genannt, führen jedoch bei solch kleinen Gitterkonstanten in den am Maßstab abgebeugten Strahlen zu entgegengesetzten Richtungskomponenten entlang der Strichrichtung der Gitterteilung. Dadurch sind die Phasenflächen der interferierenden Signalstrahlen zueinander verkippt, was zu Interferenzstreifen und einem damit einher gehenden starken Signalabfall führen würde. Um dieses Problem zu lösen, wird ein Tripel-Prisma als Retro-Reflektor verwendet, das die Richtungskomponenten entlang der Strichrichtung der Gitterteilung invertiert und so die Teilung auf sich selbst abbildet. Die Kompensation der durch Moiré-Drehung hervorgerufenen Richtungskomponenten wird nachfolgend Moiré-Kompensation genannt. Ein Nachteil dieses Abtasprinzipes ist der in Strichrichtung, also quer zur Messrichtung, geneigte Strahlengang. Dies bewirkt, dass Abstandsänderungen zwischen Abtasteinheit und Maßstab nicht vernachlässigt werden können und zu einer Veränderung in der angezeigten Position bei gleichzeitiger Moiré-Drehung führen. Außerdem sind durch den geneigten Anbau der Abtasteinheit keine großen Abstandstoleranzen erreichbar. Ein weiteres Problem ist, dass der sog. neutrale Drehpunkt nicht auf der Maßstaboberfläche liegt, sondern im Abtastgitter.

Per Definition versteht man unter dem neutralen Drehpunkt denjenigen Punkt, um den die Abtasteinheit in Messrichtung gekippt - nachfolgend wird von Nick-Kippung gesprochen - werden kann, ohne dass sich dabei die angezeigte Position verändert. Liegt der neutrale Drehpunkt nicht auf der Maßstaboberfläche, so führen Kippungen des Maßstabs zu großen Verschiebungen der angezeigten Position, die mit Hilfe von aufwendigen Korrekturverfahren wieder eliminiert werden müssen.

Die hohen Voraussetzungen bei der Positionierung des Maskentisches erfordern also eine Positionsmesseinrichtung, bei der einerseits der neutrale Drehpunkt auf der Maßstabteilung liegt und zusätzlich Moiré-Drehungen kompensiert werden. Darüber hinaus soll der Maßstab senkrecht beleuchtet werden, um eine hohe Symmetrie zu gewährleisten, was zum einen große Abstandstoleranzen zulässt, zum anderen Probleme bei der Positionsbestimmung für den Fall einer Abstandsänderung und einer gleichzeitigen Moiré-Drehung der Abtasteinheit vermeidet.

Aufgabe der vorliegenden Erfindung ist es somit, eine hochauflösende, verkippungsunempfindliche Positionsmesseinrichtung anzugeben, die in einem großen Abtastabstandsbereich zuverlässig arbeitet und zudem Fehlmessungen im Fall einer Moiré-Drehung des Abtastkopfes vermeidet.

Diese Aufgabe wird gelöst durch eine Positionsmesseinrichtung mit den Merkmalen im kennzeichnenden Teil des Anspruches 1.

Vorteilhafte Ausführungsformen der erfindungsgemäßen Vorrichtung ergeben sich aus den Maßnahmen, die in den abhängigen Patentansprüchen aufgeführt sind.

Die erfindungsgemäßen Maßnahmen gewährleisten nunmehr, dass die oben erwähnten Probleme in einer entsprechend aufgebauten Positionsmesseinrichtung nicht mehr auftreten. Insbesondere ist u.a. die erwünschte Nick-Unempfindlichkeit sowie die erwünschte Moiredrehungs-Unempfindlichkeit sichergestellt.

Realisierbar sind auf Grundlage der erfindungsgemäßen Überlegungen hierbei verschiedenste Ausführungsformen.

Weitere Vorteile und Einzelheiten der erfindungsgemäßen Positionsmesseinrichtung ergeben sich aus der nachfolgenden Beschreibung mehrerer Ausführungsbeispiele anhand der beiligenden Figuren.

Dabei zeigt
- Figur 1: den Strahlengang einer ersten Ausführungsform der erfindungsgemäßen Positionsmesseinrichtung in aufgefalteter Darstellung; .
- Figur 2a, 2b: je eine Front- und Seitenansicht des ersten Ausführungsbeispieles der erfindungsgemäßen Positonsmesseinrichtung, basierend auf dem Strahlengang gemäß Figur 1;
- Figur 3: eine Darstellung zur Erläuterung der Änderungen im Strahlengang im Fall einer eventuellen NickKippung;
- Figur 4: den Strahlengang einer zweiten Ausführungsform der erfindungsgemäßen Positionsmesseinrichtung in aufgefalteter Darstellung;
- Figur 5a, 5b: je eine Front- und Seitenansicht eines Ausführungsbeispieles des zweiten Ausführungsbeispieles der erfindungsgemäßen Positionsmesseinrichtung, basierend auf dem Strahlengang gemäß Figur 4.

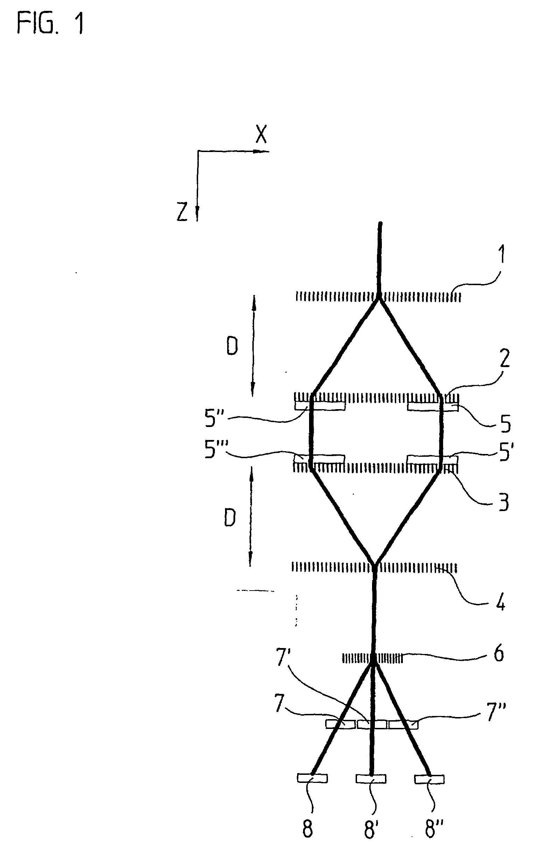

Abbildung 1 zeigt den Strahlengang einer ersten Ausführungsform der erfindungsgermäßen Positionsmesseinrichtung in aufgefalteter Darstellung. In diesem Beispiel handelt es sich um einen 4-Gitter-Geber bei dem alle Gitter bzw. Teilungen dieselbe Gitterkonstante bzw. Teilungsperiode besitzen.

Das Maßstabgitter 1 wird senkrecht mit einem kollimierten linear polarisierten Laserstrahl beleuchtet, der von einer in Figur 1 nicht dargestellten Lichtquelle emittiert wird. Die Teilung verläuft entlang der x-Richtung. Die durch Beugung am Maßstabsgitter 1 hervorgehenden Lichtbündel propagieren zum ersten Abtastgitter 2, welches im Abstand D zum Maßstabgitter angeordnet ist. Von Bedeutung sind hierbei die +/- ersten Beugungsordnungen. Durch Beugung am ersten Abtastgitter 2, werden die beiden Strahlenbündel gerade gerichtet und propagieren zum zweiten Abtastgitter 3. Dabei durchquert jedes der beiden Strahlenbündel zwei polarisationsoptische Verzögerungselemente, ausgebildet als λ/8-Plättchen 5, 5' bzw. 5",5"', welche jeweils einem Abtastgitter 2, 3 zugeordnet sind. Alternativ hierzu könnte auch je ein λ/4-Plättchen anstelle von zwei λ/8-Plättchen verwendet werden. Dadurch entsteht ein links- und ein rechtszirkular polarisiertes Strahlenbündel. Am zweiten Abtastgitter 3 werden die Strahlenbündel in +/- erste Beugungsordnungen abgelenkt und propagieren zum Maßstabgitter 4, wo sie sich in einem Punkt überlagern. Durch Beugung am Maßstabgitter 4 werden die interferierenden Strahlenbündel in die gleiche Richtung senkrecht zum Maßstabgitter 4 zurückgelenkt. Durch die Überlagerung der beiden zirkularpolarisierten Lichtbündel, deren Phasenverschiebung von der Maßstabverschiebung abhängt, entsteht ein linear polarisierter Ausgangsstrahl, bei dem die Polarisationsrichtung von der Maßstabsverschiebung in Messrichtung (x-Richtung) abhängt.

Ein nachfolgend positioniertes Gitter 6 spaltet das Strahlenbündel in drei Teilstrahlen auf, so dass mit einer Anordnung von drei Polarisatoren 7, 7', 7" unterschiedlicher Orientierung und zugehörigen Photoelementen 8, 8', 8" drei um jeweils 120° zueinander phasenverschobene Signale erzeugt werden können. Die Signalperiode entspricht einem Viertel der Gitterperiode des Maßstabgitters.

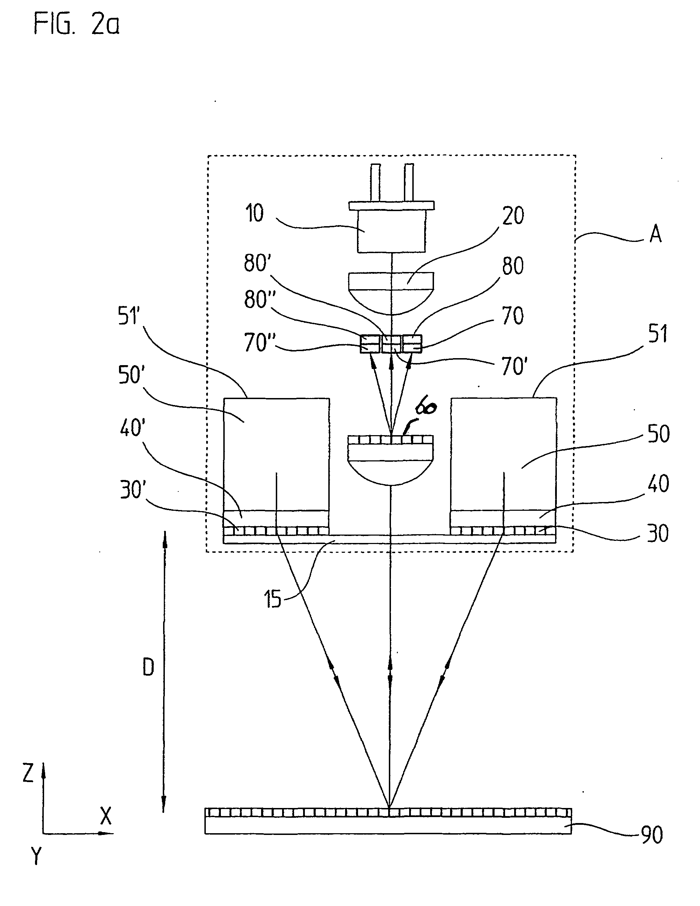

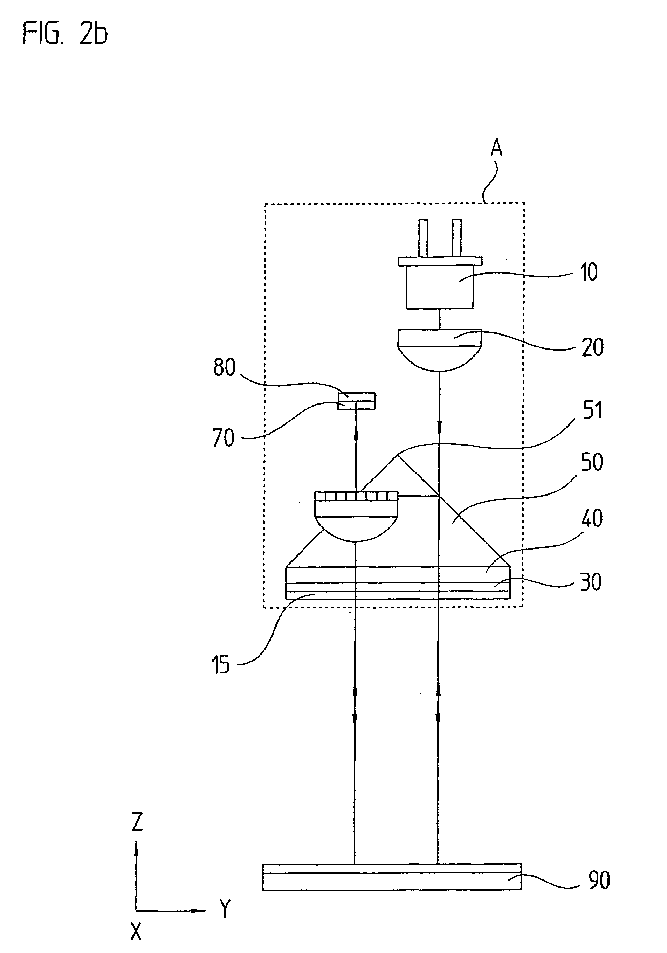

Figuren 2a und 2b zeigen ein konkretes erstes Ausführungsbeispiel des 4-Gitter-Gebers, basierend auf dem Strahlengang von Figur 1, in Front- und Seitenansicht.
Die Beleuchtung erfolgt z.B. über eine als Laserdiode 10 ausgebildete Lichtquelle bei λ=780nm mit nachfolgender Kollimationsoptik 20. Die Optik der Abtasteinheit A besteht aus den Abtastgittem 30, 30', den λ/8-Plättchen 40, 40', den Dachkantprismen 50, 50' aus Glas, sowie Polarisatoren 70, 70', 70" und Photoelementen 80, 80', 80" zur Signalgewinnung.

Der Maßstab 90 oder Maßkörper, letzterer z.B. ausgebildet als Zerodur-Maskentisch, trägt eine reflektierende Phasenteilung mit der Gitterkonstanten d=2µm. Im Abstand D=15mm von der Maßstabteilung befinden sich zwei Dachkantprismen 50, 50', jeweils ausgebildet als 90°-Prismen, an deren Unterseiten, d.h. an den Seiten, die dem Maßstab 90 zugewandt sind, Abtastgitter 30, 30' in Form von Transmissionsgittern mit Phasenteilung, mit der gleichen Gitterkonstanten von d=2µm angebracht sind. Die beiden Dachkantprismen 50, 50' und Abtastgitter 30, 30' können z.B. auf einer gemeinsamen Trägerplatte 15 befestigt werden. Im vorliegnden Ausführungsbeispiel sind die beiden Dachkantprismen 50, 50' in Messrichtung x beabstandet voneinander angeordnet.

Alternativ zum erläuterten Ausführungsbeispiel auch ein einzelnes Dachkantprisma 50, 50' mit Abtastgitter 30, 30' mit Bohrungen oder Aussparungen zur Strahlein- und -auskopplung verwendet werden. Die Kombination aus Dachkantprisma 50, 50' und Abtastgittem 30, 30' wird nachfolgend als auch Umlenkelement bezeichnet.

Trifft ein von der Lichtquelle 10 emittiertes, kollimiertes Lichtbündel senkrecht und mittig zwischen der Anordnung der Dachkantprismen 50,50' auf den Maßstab 90, so entstehen zwei +/- erste Beugungsordnungen, die nach der ersten Reflexion zurück auf die Unterseite der Dachkant-Prismen 50, 50' gelenkt werden. Durch Beugung an den Abtastgittern 30, 30' werden die Strahlenbündel vor dem Eintritt in die Dachkant-Prismen 50, 50' und dem nachfolgenden Durchlauf derselben gerade, d.h. senkrecht zum Maßstab 90, gerichtet. Die Dachkant-Prismen 50, 50' lenken die Teilstrahlen in z- und y-Richtung um und erzeugen dadurch einen Ortsversatz in y-Richtung. Beim Durchgang der Strahlenbündel durch die Umlenkelemente werden neben den Abtastgittern 30, 30' auch die λ/8-Plättchen 40, 40' je zweimal durchlaufen. Aufgrund der erfindungsgemäß gewählten Orientierung des mindestens einen Dachkantprismas 50, 50' parallel zur Messrichtung x wirkt das Dachkantprisma 50, 50' in der y-Richtung als Retro-Reflektor. Diese Richtung y ist in der Ebene des Maßstabes 90 senkrecht zur Messrichtung x ausgerichtet. Nach dem Austritt aus den Dachkant-Prismen 50, 50' werden durch wiederholte Beugung am Abtastgitter 30, 30' Strahlenbündel erzeugt, die zurück zum Maßstab 90 propagieren und sich dort überlagern. Das interferierende Strahlenbündel wird durch die zweite Reflexion bzw. Beugung am Maßstab 90 in z-Richtung, d.h. in Richtung der Detektorelemente, zurückgelenkt und trifft auf eine Anordnung aus Kollimatorlinse und Aufspaltgitter 60. Am Aufspaltgitter 60 entstehen drei Teilstrahlenbündel. Die Signalgewinnung aus diesen drei Strahlenbündeln erfolgt in bekannter Art über die Polarisatoren 70, 70', 70", die die Teilstrahlenbündel durchlaufen, bevor sie auf die Photoelemente 80, 80', 80" auftreffen, an denen dann phasenverschobene Signale resultieren. In Verbindung mit dem Aufspaltgitter 60 sei auf die EP 481 356 B1 der Anmelderin verwiesen.

Moiré-Drehungen des Maßstabs 90 erzeugen in erster Linie eine entgegengesetzte y-Ablenkung der beiden gebeugten Strahlenbündel beim ersten Auftreffen auf den Maßstab 90. Moiré-Drehungen werden nun durch die Kombination von Abtastgittem 30, 30' und die erfindungsgemäße Wahl und Anordnung der Dachkant-Prismen 50, 50' kompensiert, da das Dachkantprisma 50, 50' in y-Richtung wie ein Retro-Reflektor wirkt, d.h. die y-Komponenten der Strahlrichtungen der beiden Strahlenbündel invertiert. Nach der zweiten Beugung bzw. Reflexion am Maßstab 90 resultiert dann keine y-Komponente in der Strahlrichtung der beiden homologen Strahlenbündel mehr, also auch keine Winkeldifferenz. Dadurch werden unterschiedliche Austrittsrichtungen vermieden, es entsteht kein Streifensystem und kein dadurch bedingter Signalabfall.

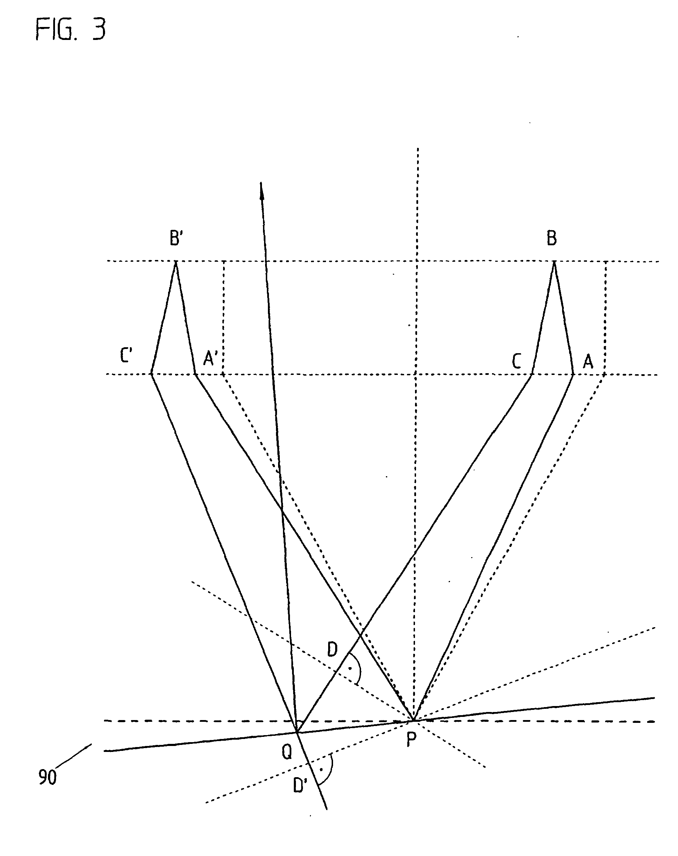

Anhand von Figur 3 soll nunmehr die Änderung des Strahlengangs bei Nick-Kippung veranschaulicht werden. Die Senkrechte zum nicht verkippten Maßstab 90 wird im Nachfolgenden als Normalenrichtung bezeichnet. Wird der Maßstab 90 im Punkt P um einen kleinen Winkel θ relativ zur Normalenrichtung gekippt, so ändern sich die Beugungswinkel α der Teilstrahlen PA und PA' zu etwa α-2θ bzw. α+2θ bezüglich der Normalenrichtung. Das bedeutet, dass das eine Strahlenbündel unter einem größeren und das andere Strahlenbündel unter einem kleineren Winkel zum Abtastgitter propagiert als dies bei nicht gekippten Maßstab 90 der Fall wäre. Das Abtastgitter ist nun nicht in der Lage die Strahlenbündel gerade zu richten. Es resultieren Winkel von +2θ und -2θ, die sich beim Eintritt in das Dachkant-Prisma entsprechend der Brechung ändern. Die Strahlenbündel werden deshalb bei ihrem Weg durch das Prisma ABC bzw. A'B'C' um die gleiche Strecke AC=A'C' in Messrichtung versetzt.

Durch die erneute Beugung am Abtastgitter ergeben sich für die Strahlen CQ und C'Q etwa die Winkel α+2θ und α-2θ bezüglich der Normalenrichtung. Dabei stimmen die Winkel von PA und C'Q bzw. von CQ und PA' jeweils überein. Die Vereinigung der beiden Strahlenbündel erfolgt im Punkt Q. Insgesamt hat jedes Strahlenbündel ein flacheres und ein steileres Teilstück zurückzulegen. Bei genauerer Betrachtung kann man feststellen, daß keine Phasendifferenzen bei der Propagation beider Strahlenbündel auftreten. Insbesondere ist auch die Austrittsrichtung beider Strahlenbündel bezüglich der Normalenrichtung gleich und es entstehen keine Interferenzstreifen, die mit einem Signalabfall verbunden wären. So resultiert keine Phasenverschiebung der interferierenden Lichtbündel aufgrund von Nick-Kippungen, so dass die ursprüngliche gemessene Position bei Nick-Kippung erhalten bleibt. Der neutrale Drehpunkt liegt damit wie gewünscht auf der Maßstabsoberfläche.

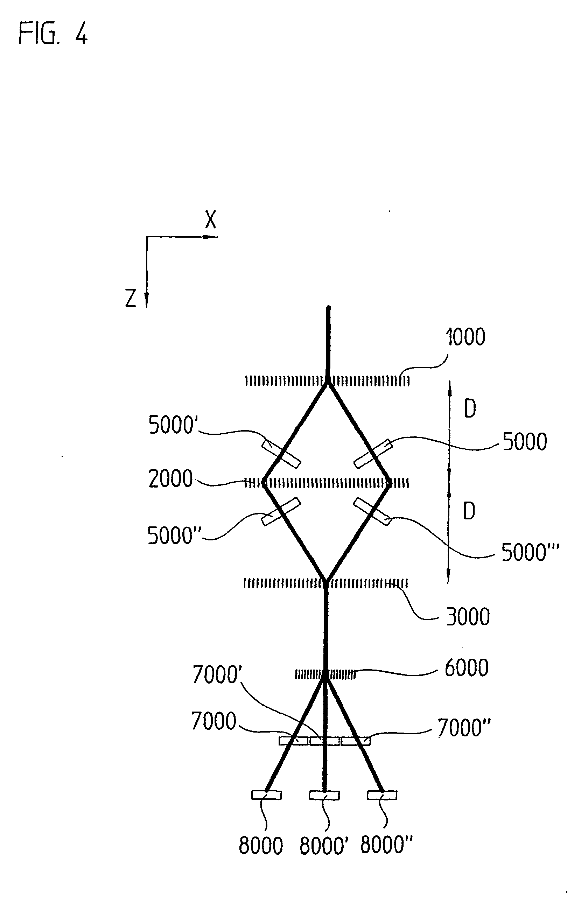

Figur 4 zeigt den prinzipiellen Strahlengang einer zweiten Ausführungsform der erfindungsgemäßen Positionsmesseinrichtung, das nunmehr auf dem Abtastprinzip eines 3-Gitter-Gebers basiert.

Die zunächst auf den Maßstab 1000 auftreffenden Strahlen werden wiederum gebeugt und durchqueren anschließend die Verzögerungsplättchen 5000, 5000'. Im Gegensatz zum vorher erläuterten 4-Gittergeber werden die Strahlen durch das Abtastgitter 2000, welches jetzt die halbe Gitterperiode in Bezug auf die Maßstabgitterperiode besitzt, nicht gerade gerichtet, sondern durch Littrow-Beugung in x-Richtung umgelenkt. Sie durchqueren anschließend die Verzögerungsplättchen 5000", 5000'" und vereinigen sich schließlich auf dem Maßstab 3000, wo die beiden interferierenden Strahlenbündel durch Beugung senkrecht zum Maßstab 3000 ausgerichtet werden. Die nachfolgende Verarbeitung der interferierenden Strahlenbündel ist identisch zum oben erläuterten Beispiel.

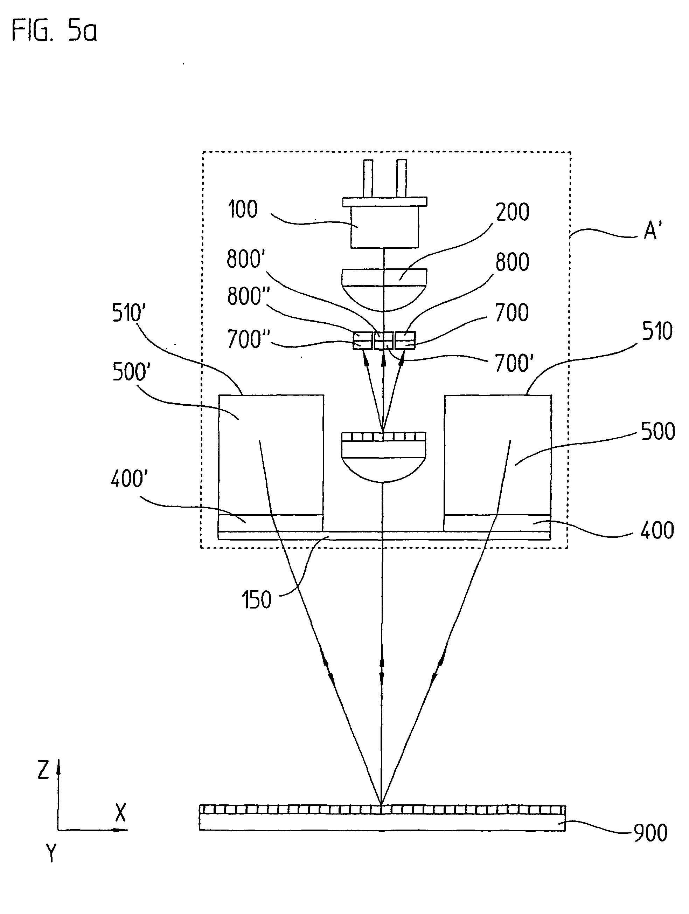

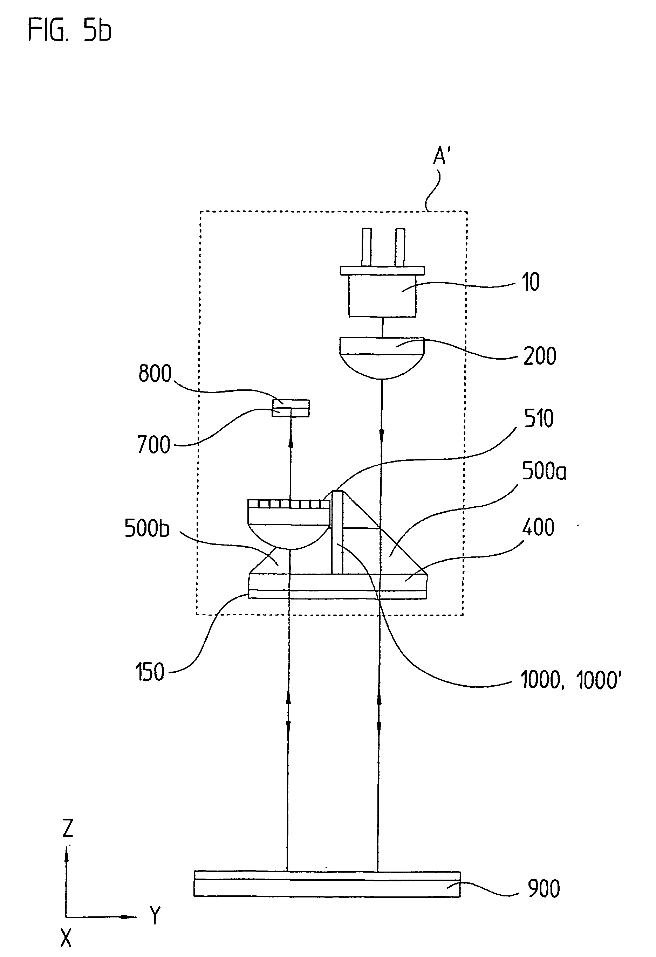

Figuren 5a und 5b zeigen wiederum ein konkretes zweites Ausführungsbeispiel des 3-Gitter-Gebers, basierend auf dem Strahlengang von Figur 4, in Front- und Seitenansicht.

Der wesentliche Unterschied zu ersten Variante besteht darin, dass die Abtastgitter 1000, 1000' sich nun nicht mehr an der Unterseite der Dachkantprismen 500, 500' befinden. Vielmehr müssen sie senkrecht zur Unterseite angebracht werden, so dass sie zwischen Prismenspitze und Prismenunterseite stehen. Dies kann z.B. dadurch realisiert werden, dass zwei Prismenteile 500a, 500b auf das Abtastgitter 1000, 1000' aufgekittet werden. Alternativ könnte anstelle von Dachkant-Prismen auch Dachkantspiegel verwendet werden.

Der Vorteil dieses System liegt darin, dass die Richtungsumlenkung in Messrichtung mit nur einem Abtastgitter 1000, 1000' erfolgen kann, sofern die Littrow-Bedingung (Gitterkonstante des Abtastgitters = halbe Gitterkonstante des Maßstabs) eingehalten wird. Dadurch geht weniger Licht durch Beugung in nicht genutzte Beugungsordnungen verloren als dies bei dem vorher beschriebenen Abtastsystem mit zwei Abtastgittem der Fall ist.

Ansonsten entsprechen die Funktionen der dargestellten Elemente denjenigen des vorhergehenden Beispiels. So ist wiederum den Abtastgittem 1000, 1000' jeweils ein polarisationsoptisches Verzögerungselement 400, 400' zugeordnet. Grundsätzlich könnte anstelle der Anordnung von zwei in Messrichtung x beabstandeten Dachkantprismen 500, 500' auf einer gemeinsamen Trägerplatte 150 auch wiederum ein einzelnes Dachkantprisma verwendet werden, das die entsprechende Länge besitzt.

Hinsichtlich des Abtaststrahlenganges ist wiederum vorgesehen, dass die von der Lichtquelle 100 emittierten Strahlenbündel zunächst auf den Maßstab 900 auftreffen und von dort eine erste Reflexion und Beugung in Richtung des mindestens einen Dachkantprismas 500, 500' erfolgt. Über das Dachkantprisma 500, 500' erfolgt eine Rückreflexion in Richtung des Maßstabes 900, ehe eine zweite Reflexion der Strahlenbündel vom Maßstab 900 in Richtung der Detektorelemente 800, 800', 800" resultiert. Aufgrund der unterschiedlichen Ausgestaltung des bzw. der Dachkantprismen 500, 500' durchlaufen nach der ersten Reflexion auf dem Maßstab 900 die Strahlenbündel im Dachkantprisma 500, 500' das Abtastgitter 1000, 1000' jeweils nur einmal.

Die beiden erläuterten Ausführungsbeispiele können in den nachfolgend erläuterten Punkten einfach modifiziert werden.

So können etwa verschiedene Lichtquellen eingesetzt werden. Da keine Gangunterschiede auftreten und die beiden interferierenden Strahlenbündel am gleichen Ort vereinigt werden, können auch zeitlich und/oder räumlich teil- bzw. inkohärente Lichtquellen verwendet werden. Dazu gehören neben mono- oder multimodigen Streifenleiter-Halbleiterlasern auch VCSELs, wobei auch transversal multimodige Typen eingesetzt werden können. Aber selbst LEDs lassen sich verwenden.

Um Probleme mit Dissipationsverlusten zu vermeiden kann die Lichtquelle von der Abtasteinheit getrennt und über eine Lichtleitfaser mit diesem verbunden werden. Wird die Signalgewinnung über die Auswertung von Polarisationszuständen realisiert sind polarisationserhaltende Fasern zu verwenden.

Das Umlenkelement kann desweiteren durch eine Kombination aus Zylinderlinse und Spiegel ersetzt werden. Dabei kann die Zylinderlinse auch als Fresnelzylinderlinse oder Fresnelzylinderzonenplatte ausgeführt werden.

Die Dachkantprismen können ferner durch Dachkantspiegel ersetzt werden, d.h. durch eine Anordnung von zwei Spiegelflächen, die unter einem 90°-Winkel zueinander angeordnet sind. Alternativ wäre auch der Einsatz von einfache Kunststoffprismen möglich.

Zur Signalerzeugung kann anstelle der Polarisatoren vor den Photoelementen eine in der Interferometrie übliche Anordnung aus polarisierenden Strahlteilern verwendet werden, bei der vier um je 90° phasenverschobene Signale erzeugt werden.

Anstatt das Messsignal aus dem Polarisationszustand des Laserlicht zu erzeugen ist es ebenfalls möglich die Gitterkonstanten von Maßstabgitter und Abtastgitter leicht verschieden zu wählen. Auf diese Weise entsteht durch die Interferenz der beiden Strahlenbündel am Maßstab ein Intensitätsstreifensystem, welches hier als Vemierstreifensystem bezeichnet wird. Dieses wird auf Detektorelemente in Form eines strukturierten Photosensors in der Abtasteinheit übertragen oder abgebildet. Der strukturierte Photosensor muss dazu eine Fingerstruktur (mehrere seitlich nebeneinander angeordnete gleichgroße rechteckige Photoelemente) besitzen. Die einzelnen Photoelemente werden so verschaltet, dass drei um 120° oder vier um 90° verschoben Signalströme entstehen, wenn das Vemierstreifensystem die Photoelement überstreicht. Anstelle eines Vemierstreifensystems kann auch ein Moirestreifensystem erzeugt werden, das entsteht, wenn die Abtastgitter ein wenig um die Normalenrichtung des Maßstabs (z-Richtung) gedreht werden.

Im Rahmen der vorliegenden Erfindung existieren somit neben den erläuterten Beispielen eine Reihe von weiteren Ausführungsmöglichkeiten.

## Patentansprüche

1. Positionsmesseinrichtung zur Erfassung der Relativposition einer Abtasteinheit und einem hierzu in mindestens einer Messrichtung verschiebbaren Maßstab, wobei die Abtasteinheit mindestens ein Abtastgitter, mindestens ein Umlenkelement, sowie mehrere optoelektronische Detektorelemente umfasst,
**dadurch gekennzeichnet, dass**
als Umlenkelement mindestens ein Dachkantprisma (50, 50'; 500, 500') in der Abtasteinheit (A; A') angeordnet ist, dessen Dachkante (51, 51'; 510, 510') parallel zur Messrichtung (x) orientiert ist und das in einer Richtung (y) als Retro-Reflektor wirkt, die in der Ebene des Maßstabes (90; 900) senkrecht zur Messrichtung (x) ausgerichtet ist.

2. Positionsmesseinrichtung nach Anspruch 1, **dadurch gekennzeichnet, dass** an der Seite des Dachkantprismas (50, 50'), die dem Maßstab (90) zugeordnet ist, das Abtastgitter (30, 30') angeordnet ist.

3. Positionsmesseinrichtung nach Anspruch 2, **dadurch gekennzeichnet, dass** dem Abtastgitter (30, 30') ein polarisationsoptisches Verzögerungselement (40, 40') zugeordnet ist.

4. Positionsmesseinrichtung nach einem der vorhergehenden Ansprüche, **dadurch gekennzeichnet, dass** die Abtasteinheit (A) zwei Dachkantprismen (50, 50') umfasst, die in Messrichtung (x) beabstandet voneinander angeordnet sind.

5. Positionsmesseinrichtung nach Anspruch 4, **dadurch gekennzeichnet, dass** die beiden Dachkantprismen (50, 50') auf einer gemeinsamen Trägerplatte (15) angeordnet sind.

6. Positionsmesseinrichtung nach Anspruch 1, **dadurch gekennzeichnet, dass** die von der Lichtquelle (10) emittierten Strahlenbündel zunächst auf den Maßstab (90) auftreffen, von dort eine erste Reflexion in Richtung des mindestens einen Dachkantprismas (50, 50') erfolgt, seitens des Dachkantprismas (50, 50') eine Rückreflexion in Richtung des Maßstabes (90) erfolgt, ehe eine zweite Reflexion der Strahlenbündel vom Maßstab (90) in Richtung der Detektorelemente (80, 80', 80") erfolgt.

7. Positionsmesseinrichtung nach Anspruch 6, **dadurch gekennzeichnet, dass** nach der ersten Reflexion auf dem Maßstab (90) die Strahlenbündel vor dem Eintritt in das Dachkantprisma (50, 50') das Abtastgitter (30, 30') ein erstes Mal durchlaufen, durch das die Strahlenbündel eine Ablenkung dergestalt erfahren, dass diese senkrecht auf den Maßstab (90) ausgerichtet sind und die Strahlenbündel das Abtastgitter (30, 30') nach dem Austritt aus dem Dachkantprisma (50, 50') ein zweites Mal durchlaufen.

8. Positionsmesseinrichtung nach Anspruch 1, **dadurch gekennzeichnet, dass** das Abtastgitter (1000, 1000') stehend zwischen der Spitze und der Unterseite des Dachkantprismas (500, 500') angeordnet ist.

9. Positionsmesseinrichtung nach Anspruch 8, **dadurch gekennzeichnet, dass** dem Abtastgitter (1000, 1000') ein polarisationsoptisches Verzögerungselement (400, 400') zugeordnet ist.

10. Positionsmesseinrichtung nach einem der Ansprüche 8 oder 9, **dadurch gekennzeichnet, dass** die Abtasteinheit (A') zwei Dachkantprismen (500, 500') umfasst, die in Messrichtung (x) beabstandet voneinander angeordnet sind.

11. Positionsmesseinrichtung nach Anspruch 10, **dadurch gekennzeichnet, dass** die beiden Dachkantprismen (500, 500') auf einer gemeinsamen Trägerplatte (150) angeordnet sind.

12. Positionsmesseinrichtung nach Anspruch 8, **dadurch gekennzeichnet, dass** die von der Lichtquelle (100) emittierten Strahlenbündel zunächst auf den Maßstab (900) auftreffen, von dort eine erste Reflexion in Richtung des mindestens einen Dachkantprismas (500, 500') erfolgt, seitens des Dachkantprismas (500, 500') eine Rückreflexion in Richtung des Maßstabes (900) erfolgt, ehe eine zweite Reflexion der Strahlenbündel vom Maßstab (900) in Richtung der Detektorelemente (800, 800', 800") erfolgt.

13. Positionsmesseinrichtung nach Anspruch 12, **dadurch gekennzeichnet, dass** nach der ersten Reflexion auf dem Maßstab (900) die Strahlenbündel im Dachkantprisma (500, 500') das Abtastgitter (1000, 1000') einmal durchlaufen.

14. Positionsmesseinrichtung nach Anspruch 8, **dadurch gekennzeichnet, dass** das Dachkantprisma (500, 500') aus zwei Prismenteilen (500a, 500b) besteht, die beidseitig auf das Abtastgitter (1000, 1000') aufgekittet sind.

15. Positionsmesseinrichtung nach Anspruch 1, **dadurch gekennzeichnet, dass** das Dachkantprisma zwei Spiegelflächen umfasst, die unter einem Dachkant-Winkel von 90° zueinander angeordnet sind.

16. Positionsmesseinrichtung nach Anspruch 1, **dadurch gekennzeichnet, dass** vor den Detektorelementen ein Aufspaltgitter angeordnet ist, welches das auftreffende Strahlenbündel in mehrere Teilstrahlen aufspaltet, die wiederum Polarisatoren unterschiedlicher Orientierung durchlaufen, so dass die Detektorelemente phasenverschobene Signale erfassen.

17. Positionsmesseinrichtung nach Anspruch 1, **dadurch gekennzeichnet, dass** die Lichtquelle getrennt von der Abtasteinheit angeordnet und mit dieser über eine Lichtleitfaser verbunden ist.

18. Positionsmesseinrichtung nach Anspruch 1, **dadurch gekennzeichnet, dass** die Gitterkonstanten des Maßstabes und des Abtastgitters geringfügig verschieden gewählt sind und als Detektorelemente ein strukkturierter Photosensor in der Abtasteinheit angeordnet ist.

## Claims

1. Position measuring device for detecting the relative position of a scanning unit and a scale which can be displaced in relation to it in at least one measuring direction, the scanning unit comprising at least one scanning grating, at least one deflection element as well as a plurality of optoelectronic detector elements,
**characterised in that**
at least one ridge prism (50, 50'; 500, 500') is arranged in the scanning unit (A; A') as the deflection element, the ridge (51, 51'; 510, 510') of which is oriented parallel to the measuring direction (x) and which acts as a retro-reflector in a direction (y) which is aligned in the plane of the scale (90; 900) perpendicular to the measuring direction (x).

2. Position measuring device according to claim 1, **characterised in that** the scanning grating (30, 30') is arranged on the side of the ridge prism (50, 50') associated with the scale (90).

3. Position measuring device according to claim 2, **characteriaed in that** a polarisation-optical retardation element (40, 40') is associated with the scanning grating (30, 30').

4. Position measuring device according to one of the preceding claims, **characterised in that** the scanning unit (A) comprises two ridge prisms (50, 50') which are arranged spaced apart from one another in the measuring direction (x).

5. Position measuring device according to claim 4, **characterised in that** the two ridge prisms (50, 50') are arranged on a common support plate (15).

6. Position measuring device according to claim 1, **characterised in that** the light beams emitted by the light source (10) initially impinge on the scale (90), from there a first reflection takes place in the direction of the at least one ridge prism (50, 50'), a back reflection in the direction of the scale (90) takes place from the ridge prism (50, 50') before a second reflection of the light beams from the scale (90) in the direction of the detector elements (80, 80', 80") takes place.

7. Position measuring device according to claim 6, **characterised in that** after the first reflection on the scale (90), the light beams pass a first time through the scanning grating (30, 30') before entering the ridge prism (50, 50'), by which the beams are deflected in such a way that they are aligned vertically towards the scale (90) and the light beams pass through the scanning grating (30, 30') a second time after exiting from the ridge prism (50, 50').

8. Position measuring device according to claim 1, **characterised in that** the scanning grating (1000, 1000') is arranged upright between the tip and the underside of the ridge prism (500, 500').

9. Position measuring device according to claim 8, **characterised in that** a polarisation-optical retardation element (400, 400') is associated with the scanning grating (1000, 1000').

10. Position measuring device according to one of claims 8 or 9, **characterised in that** the scanning unit (A') comprises two ridge prisms (500, 500') which are arranged spaced apart from one another in the measuring direction (x).

11. Position measuring device according to claim 10, **characterised in that** the two ridge prisms (500, 500') are arranged on a common support plate (150).

12. Position measuring device according to claim 8, **characterised in that** the light beams emitted from the light source (100) initially impinge on the scale (900), from there a first reflection takes place in the direction of the at least one ridge prism (500, 500'), a back reflection in the direction of the scale (900) takes place from the ridge prism (500, 500') before a second reflection of the light beams from the scale (900) in the direction of the detector elements (800, 800', 800") takes place.

13. Position measuring device according to claim 12, **characterised in that** after the first reflection on the scale (900), the light beams in the ridge prism (500, 500') pass once through the scanning grating (1000, 1000').

14. Position measuring device according to claim 8, **characterised in that** the ridge prism (500, 500') comprises two prism elements (500a, 500b) which are cemented on both sides to the scanning grating (1000, 1000').

15. Position measuring device according to claim 1, **characterised in that** the ridge prism includes two mirror surfaces which are arranged at a ridge angle of 90° relative to one another.

16. Position measuring device according to claim 1, **characterised in that** a splitting grating is arranged in front of the detector elements which splits the impinging light beam into a plurality of partial beams, which in turn pass through polarizers of different orientation such that the detector elements detect phase-shifted signals.

17. Position measuring device according to claim 1, **characterised in that** the light source is arranged separate from the scanning unit and is connected to the latter via an optical fibre.

18. Position measuring device according to claim 1, **characterised in that** the grating constants of the scale and of the scanning grating are selected to be slightly different and a structured photosensor is arranged in the scanning unit as the detector elements.

## Revendications

1. Dispositif de mesure de position pour mesurer la position relative d'une unité de palpage et d'une règle de mesure qui coulisse par rapport à celle-ci dans au moins une direction de mesure, l'unité de palpage comprenant au moins un réseau de palpage, au moins un élément de déviation ainsi que plusieurs éléments détecteurs optoélectroniques, **caractérisé par le fait qu'**il est prévu dans l'unité de palpage (A ; A'), comme élément de déviation, au moins un prisme triangulaire (50, 50' ; 500, 500'), dont l'arête de sommet (51, 51' ; 510, 510') est orientée parallèlement à la direction de mesure (x) et qui agit en élément rétroréfléchissant dans une direction (y) orientée perpendiculairement à la direction de mesure (x) dans le plan de la règle de mesure (90, 900).

2. Dispositif de mesure selon la revendication 1, **caractérisé par le fait que** le réseau de palpage (30, 30') est disposé sur le côté du prisme triangulaire (50, 50') associé à la règle de mesure (90).

3. Dispositif de mesure selon la revendication 2, **caractérisé par le fait qu'**un élément retardateur (40, 40') optique à polarisation est associé au réseau de palpage (30, 30').

4. Dispositif de mesure selon une des revendications précédentes, **caractérisé par le fait que** l'unité de palpage (A) comprend deux prismes triangulaires (50, 50') qui sont disposés espacés l'un' de l'autre dans la direction de mesure (x).

5. Dispositif de mesure selon la revendication 4, **caractérisé par le fait que** les deux prismes triangulaires (50, 50') sont disposés sur une plaque support (15) commune.

6. Dispositif de mesure selon la revendication 1, **caractérisé par le fait que** les faisceaux de rayons émis par la source lumineuse (10) frappent d'abord la règle de mesure (90), que de là une première réflexion a lieu en direction du prisme triangulaire (50, 50') au nombre d'au moins un, que côté prisme triangulaire (50, 50') une rétro-réflexion a lieu en direction de la règle de mesure (90) avant que se produise une deuxième réflexion des faisceaux de rayons sur la règle de mesure (90) en direction des éléments détecteurs (80, 80', 80").

7. Dispositif de mesure selon la revendication 6, **caractérisé par le fait qu'**après la première réflexion sur la règle de mesure (90), les faisceaux de rayons avant leur entrée dans le prisme triangulaire (50, 50') traversent une première fois le réseau de palpage (30, 30'), dans lequel les faisceaux de rayons subissent une première déviation qui les amène perpendiculairement à la règle de mesure, et que les faisceaux de rayons après leur sortie du prisme triangulaire (50, 50') traversent une seconde fois le réseau de palpage (30, 30').

8. Dispositif de mesure selon la revendication 1, **caractérisé par le fait que** le réseau de palpage (1000, 1000') est disposé dressé entre le sommet et la face inférieure du prisme triangulaire (500, 500').

9. Dispositif de mesure selon la revendication 8, **caractérisé par le fait qu'**un élément retardateur (400, 400') optique à polarisation est associé au réseau de palpage (1000, 1000').

10. Dispositif de mesure selon une des revendications précédentes, **caractérisé par le fait que** l'unité de palpage (A') comprend deux prismes triangulaires (500, 500') qui sont disposés espacés l'un de l'autre dans la direction de mesure (x).

11. Dispositif de mesure selon la revendication 4, **caractérisé par le fait que** les deux prismes triangulaires (500, 500') sont disposés sur une plaque support (150) commune.

12. Dispositif de mesure selon la revendication 8, **caractérisé par le fait que** les faisceaux de rayons émis par la source lumineuse (100) frappent d'abord la règle de mesure (900), que de là une première réflexion a lieu en direction du prisme triangulaire (500, 500') au nombre d'au moins un, que côté du prisme triangulaire (500, 500') une rétro-réflexion a lieu en direction de la règle de mesure (900) avant qu'intervienne une deuxième réflexion des faisceaux de rayons sur la règle de mesure (900) en direction des éléments détecteurs (800, 800', 800").

13. Dispositif de mesure selon la revendication 12, **caractérisé par le fait qu'**après la première réflexion sur la règle de mesure (900), les faisceaux de rayons dans le prisme triangulaire (500, 500') traversent une fois le réseau de palpage (1000, 1000').

14. Dispositif de mesure de position selon la revendication 8, **caractérisé par le fait que** le prisme triangulaire (500, 500') est formé de deux prismes élémentaires (500a, 500b) qui sont collés de part et d'autre sur le réseau de palpage (1000, 1000').

15. Dispositif de mesure de position selon la revendication 1, **caractérisé par le fait que** le prisme triangulaire comprend deux surfaces réfléchissantes qui forment entre elles un angle 90°.

16. Dispositif de mesure de position selon la revendication 1, **caractérisé par le fait que** devant les éléments détecteurs est disposé un réseau de diffraction qui sépare le faisceau de rayons entrant en plusieurs faisceaux partiels, lesquels faisceaux partiels traversent à leur tour des polarisateurs avec des orientations différentes, de sorte que les éléments détecteurs détectent des signaux déphasés.

17. Dispositif de mesure de position selon la revendication 1, **caractérisé par le fait que** la source lumineuse est séparée de l'unité de palpage et est reliée à celle-ci par une fibre optique.

18. Dispositif de mesure de position selon la revendication 1, **caractérisé par le fait que** les constantes de réseau de la règle de mesure et du réseau de palpage sont choisies légèrement différentes et qu'un capteur photoélectrique structuré est disposé dans l'unité de palpage en tant qu'élément détecteur.
